# EUROPEAN PATENT SPECIFICATION

(11) **EP 0 539 006 B1**
(45) Date of publication and mention of the grant of the patent: **24.03.1999**
(21) Application number: 92308224.2
(22) Date of filing: 10.09.1992
(51) Int. Cl.: G03F 1/00

(54) **Method of repairing phase shifting lithographic masks**
Verfahren zur Wiederherstellung lithographischen Phasenverschiebungsmasken
Procédé de réparation de masques lithographiques à décalage de phase

(30) Priority: 20.09.1991 US 763045; 20.09.1991 US 763046
(43) Date of publication of application: 28.04.1993
(73) Proprietor: AT&T Corp., New York, NY 10013-2412 (US)
(72) Inventor: Pierrat, Christophe, Watchung, New Jersey 07060 (US)
(74) Representative: Johnston, Kenneth Graham

(56) References cited:
- EP-A- 0 493 963
- IBM TECHNICAL DISCLOSURE BULLETIN. vol. 29, no. 3, August 1986, NEW YORK US pages 1378 - 1379 'photomask repair process for opaque chrome defects'
- PATENT ABSTRACTS OF JAPAN vol. 15, no. 460 (P-1278)21 November 1991
- PATENT ABSTRACTS OF JAPAN vol. 15, no. 301 (P-1233)31 July 1991

## Description

This invention relates to optical lithography, and more particularly to a method of repairing phase-shifting masks. Such masks typically are used in optical imaging systems for lithographically fabricating microminiature devices, such as semiconductor integrated circuits. These masks are also called "reticles," particularly when used in optical focusing systems having lateral magnifications that differ from unity.

Lithographic masks have a pattern of features that are desired to be imparted into a workpiece, in order to fabricate, for example, semiconductor integrated circuits or other microminiature devices in the workpiece. Typically, the features of the mask are transferred to the workpiece by first placing the mask on the object plane of an optical imaging system that focuses optical radiation propagating through the mask, in order to transfer the features of the mask to a photoresist layer either overlying the workpiece or overlying a layer of material which overlies the workpiece. Then the photoresist layer is developed in order to form a patterned photoresist layer. Thus, the pattern of the mask features is transferred to the photoresist layer, with a magnification (greater to, equal to, or less than unity) that depends upon the design of the optical imaging system. The resulting pattern of the photoresist features is used to define features in the workpiece--such as edges of ion implant regions, edges of removed portions of the layer(s) of material overlying the workpiece to be removed, or edges of portions of the workpiece itself--all these edges thus being in accordance with the edges of the mask features.

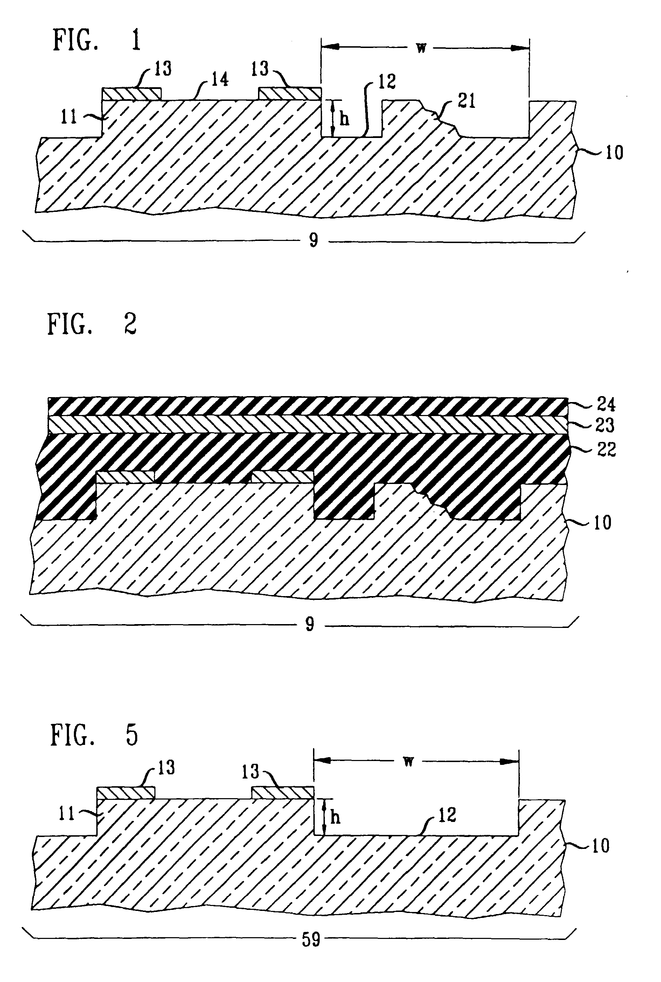

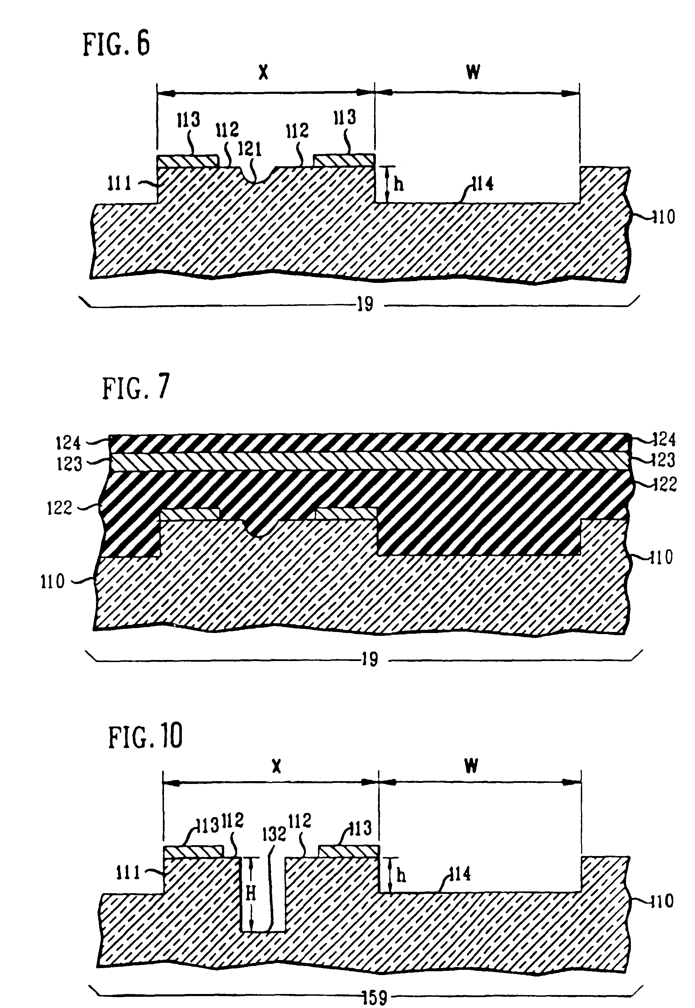

A limiting factor in thus transferring the mask features to the photoresist layer is diffraction caused by the non-vanishing wavelength λ (in the vacuum) of the optical radiation that is used in the optical imaging system. As a result of this diffraction, the edges of the images formed by the optical focusing system become less sharp than desired, whereby the resolution of the mask features when focused on the photoresist layer deteriorates. To improve this resolution, phase-shifting masks have been proposed. In these masks, the phases of the optical radiation propagating through the mask are shifted by, say, φ radian in some regions relative to others. In one example, a typical portion 9 (FIG. 1) of a prior-art phase-shifting mask (hereinafter, "mask portion 9") has an opaque chrome (chromium) layer pair 13 located on a portion of the top substantially planar surface 14 of a raised (plateau) region 11 of a transparent, typically quartz, substrate 10. The region 11 is thicker, by a distance h, than an adjacent "trench" region having a width w. This trench region has a top surface 12 which is substantially planar except for the presence of excess material--typically quartz--forming an undesired defect region 21. In another example, a typical portion 19 (FIG.6) of a prior-art phase-shifting mask (hereinafter, "mask portion 19") has an opaque chrome (chromium) layer pair 113 located on a portion of the top substantially planar surface 112 of a raised (plateua) region 111 of a transparent, typically quartz, substrate 110. The region 111 has a width x and is thicker, by a distance h, than an adjacent "trench" region having a width w. The top surface 112 of the plateua region 111 which is substantially planar except for the presence of an indentation that forms an undesired defect region 121. As used herein, the term "substantially planar" refers to a situation in which any departures from planarity do no degrade, by more than desired amounts, the sharpness of images produced (e.g., in the photoresist layer) when the mask portion 9 is used in the optical imaging system.

The distance h corresponds to the optical phase shift φ (radian). Thus, (hn)/λ - hλ=φ, or h=φλ/(n-1), where n is the refractive index of the quartz. Typically, φ = π radian; so that typically, h=π λ/(n-1). When viewed from above, the contours of the chrome layer pair 13 depend upon the contours of the ultimately desired features in the workpiece (or in a layer overlying the workpiece).

One problem that can arise in using the phase-shifting mask portion 9 is the presence of the above-mentioned defect region 21. It should be understood that, in general, the height of the defect region 21 can vary from point to point, typically anywhere between h and a tiny fraction of h, or even zero (as indicated in FIG. 1). This defect region 21 is typically composed of the same material as that of the substrate 10, typically quartz, that was not, but should have been, removed during whatever earlier processing was used to produce the trench region. Such a defect region can also be located in the plateua region 11. The surface of the indentation region in Fig. 6 can have an irregular shape, such as was formed during earlier processing. Such a defect region can also be located in the plateau region 111. Also, there can be a plurality of such defect regions, each typically (but not necessarily) being located in a different plateua or trench region.

Obviously, when the mask portion 9 is used in the optical imaging system, the presence of the defect region 21 can deteriorate the image formed by the mask portion 9 on the photoresist layer located on the workpiece. Rather than discard entirely this mask 9 having such a defect region 21 (the mask being otherwise very valuable) it is desirable to have a method of repairing the mask, i.e., a method of removing the defect region 21 without damaging the rest of the phase-shifting mask 9 (not shown). Such defect regions could be removed by techniques involving a three-dimensional inspection of the mask--for example, by means of a scanning tunneling electron microscope--followed by ion-assisted milling or laser-assisted milling of the defect region. Such ion-assisted milling (without the three-dimensional inspection required for repairing phase masks) has been described, for example, in "Mask and Circuit Repair with Focused-Ion Beams," by T.D. Cambria and N.P. Economou, published in Solid State Technology, pp. 133-136, September 1987. However, such techniques require careful three-dimensional point-by-point control of the milling in accordance with the varying height, from point to point, of the defect region 21. It would therefore be desirable to have a method for removing the defect region without necessitating three-dimensional inspection of the mask or three-dimensional control of the removal process.

In the Fourth Hoya Photomask Symposium, Japan 1991, Norio Hasegawa published a paper entitled "Submicron Photolithography using Phase-Shifting Mask". In that paper, a method was disclosed for repairing an indentation defect region in a phase-shifting mask. In accordance with that method, the defect region was present in a π-radian optical phase-shifting layer ("main shifter" layer) underneath which there was located another π-radian phase-shifting layer ("sub shifter" layer); and a barrier layer was located underneath the sub shifter layer--the barrier layer thus intervening between the bottom surface of the sub shifter layer and the top surface of a transparent substrate. This barrier layer served as an etch-stopping layer. To repair the mask, a region of both the main and the sub shifter layers laterally encompassing the defect region was etched down to the barrier layer--whereby the resulting phase shift in this (etched) region became equal to 2π, which of course is equivalent to a zero phase shift. In this way, when the mask is used in the optical imaging system, optical image deteriorations caused by the indentation defect region are ameliorated.

The need for the barrier layer in that method, however, entails a need for depositing on this barrier layer some sort of transparent material for the π and/or 2π-radian phase-shifting layers, such as chemically vapor deposited (CVD) silicon dioxide layers. The need for these deposited oxide layers complicates the fabrication of the mask's substrate, as well as the processing and etching of the chromium layer 13. This need for deposited oxide layers also complicates any required subsequent cleaning of the surface of the mask portion 9--because a chromium layer is not as adherent to a deposited silicon dioxide layer as it is to a quartz substrate; and a deposited oxide layer is not as resistant as quartz to the cleaning procedures used for cleaning the mask. Moreover, the need for these deposited oxide layers has the disadvantage of requiring very close matching of the refractive indices of the various layers. Therefore, it would be desirable to have a method of repairing indentation defect regions without the need for an intervening etch-stopping layer.

According to the present invention there is provided a method as defined in claim 1, or 2.

In the embodiment in which the defect region (Fig 1: 21) is the presence of excess material, it is advantageous that, prior to the etching, a second layer (23) is formed on the top surface of the first layer, and an aperture is then formed in the second layer overlying at least the entire lateral extent of the defect region, the second layer being resistant to the etching, whereby the aperture in the second layer defines the portion of the first layer. It is further advantageous that the second layer comprises a metal and the first layer is substantially a polymer. It is yet further advantageous that the excess material has the same composition as that of the substrate.

In the embodiment in which the defect region (Fig 6, 121) is the presence of the indentation region, it is advantageous that prior to the etching a second layer is formed on the top surface of the first layer, and an aperture is formed in the second layer overlying at least the entire lateral extent of the indentation region, the second layer being resistant to the etching, whereby the aperture in the second layer defines the portion of the first layer. It is further advantageous that the method further include, prior to step (a), the step of two-dimensionally inspecting the mask to determine the lateral extent of the indentation region. It is yet further advantageous that the depth H is equivalent to a phase shift of 2nπ with respect to optical radiation propagating through the substrate in a direction normal to the planar top surface one of the regions, where the optical radiation is to be used in an optical imaging system, and where n is an integer. It is yet further advantageous that the integer n is equal to one. It is yet further advantageous that the method further include the steps of removing the remnants of the first and second layers subsequent to step (b).

As used herein, the term "substantially anistropically" refers to a situation wherein departures from perfect anisotropical etching do not degrade by more than tolerable amounts, the sharpness of images when the mask portion 9 is used in the optical imaging system.

The lateral extent of the defect region can have been determined by an earlier conventional two-dimensional scanning optical microscope inspection of the mask.

In practicing this invention only two-dimensional (lateral) inspection of the mask--and not three-dimensional inspection--is thus required to ascertain the location and extent of each defect region. Moreover, only one-dimensional control (etch-stopping point detection) over the anistropic etching is required. Also, the technique of this invention can similarly be used to remove excess material from regions other than the trench region, such as from the raised (plateau) region 11.

In case there is a plurality of defect regions, each typically (but not necessarily) located on the surface of a separate trench (or plateau) region, the technique of this invention can be used to remove the excess material simultaneously from all of the defect regions located in the trench regions (or in the plateua regions), simply by forming a plurality of apertures in the protective layer, each aperture overlying a separate defect region.

### Brief Description of the Drawing

This invention, together with its features, characteristics, and advantages, may be better understood from the following detailed description when read in conjunction with the drawing in which:
FIGS. 1 and 6 are cross-section elevational views of portions of prior-art phase-shifting masks to be repaired in accordance with specific embodiments of the invention;
FIGS. 2-5 are cross-sectional elevational views of various stages in a method of repairing the phase-shifting mask shown in FIG. 1 in accordance with a specific embodiment of the invention; and
FIGS. 7-10 are cross-section elevational views of various stages in method of repairing the phase-shifting mask shown in FIG. 1 in accordance with another specific embodiment of the invention.

FIG. 1 depicts the phase-shifting mask portion 9 to be repaired and thus to form a repaired phase-shifting mask portion 59 (FIG.5). The mask portion 9 includes a transparent essentially quartz substrate 10 having a raised plateau (thicker) region 11 with a top surface 14. As used herein, the term "substantially quartz" includes commercial grade quartz, viz., non-pure quartz as is commercially available. The substrate 10 also has a trench (thinner) region with a top surface 12 and a width w. The top surface 12 of the trench region is located at a depth h beneath the top surface 14 of the plateua region 11. A patterned opaque chromium layer pair 13 (hereinafter, simply "the chrome layer 13") is located on the top surface 14 of the plateua region 11. Typically, the depth h corresponds to a phase-shift of π radians. The purpose of the chromium layer 13 is to supply an optically opaque portion for the phase-shifting mask portion 9, as known in the art.

The mask portion 9 has a defect region 21 illustratively composed of excess quartz material, and it is desired to remove this region 21 and thereby substantially everywhere planarize the top surface 12 of the trench region. This defect region 21 can have a variable height--i.e., a height that varies with lateral (two-dimensional) position along the surface 12, as indicated along a right-hand portion of the defect region 21 (FIG. 1).

The outermost lateral (two-dimensional) contours of the defect region are determined first, such as by an inspection with a two-dimensional scanning optical microscope.

Referring now to FIG. 2, there are then successively formed on the top surface of the mask portion 9, as well as typically on the top surface of the rest of the mask (not shown), layers 22, 23, and 24. Layer 22 is a planarization layer, typically a spun-on, essentially polymer layer, such as a polycresolformaldehyde or a polyvinylphenol, as are commercially available. Advantageously this planarization layer possesses anisotropic etching conditions for which it etches at substantially the same rate as that of the excess (quartz) material. Layer 23 is essentially chromium (possibly intermixed with some chromium oxide or other impurities) having a uniform thickness typically equal to about 0.03 µm; and layer 24 is a positive or negative tone resist layer--preferably positive tone--having a uniform thickness equal to about 0.5 µm. The thickness of planarization layer 22 at areas overlying the surface 14 of the plateau region 11 is typically equal to about 1 µm.

The resist layer 24 is exposed to a patterned beam of actinic radiation (ion beam, photon beam, or electron beam), the two-dimensional contours of the pattern being substantially the same as those of the previously determined (outermost) two-dimensional contours of the defect region 21 plus a non-zero safety margin having a width equal to s. Thus this alignment of the contours of the actinic radiation with those of the defect region need not be precise, so long as there is any safety margin (provided that the defect region 21 does not extend to an edge of the trench region). The width s of this safety margin depends on the accuracy of the method used for ascertaining the (outermost) contours of the defect region 21, as well as depends on the width w of the trench region. Typically this width s is about 0.5 µm or less.

Next, the resist layer 24 is developed, typically by a wet development, whereby it becomes a patterned resist layer. This pattern of the thus patterned resist layer 24 is then transferred to the chromium layer 23, typically by means of a standard technique such as anisotropic dry etching with a gas mixture of Cl₂ and O₂. Alternatively, by virtue of the relatively small thickness of the chromium layer 23 with respect to undercut tolerance, isotropic wet etching --for example, with ceric ammonium nitrate solution-- can also be used without inducing an unwanted undercut of the chrome features located underneath the resist features. The thus patterned chromium layer 23 will have an aperture of width equal to u overlying the defect region 21, with u being equal to the width of the defect region 21 plus twice the safety margin s.

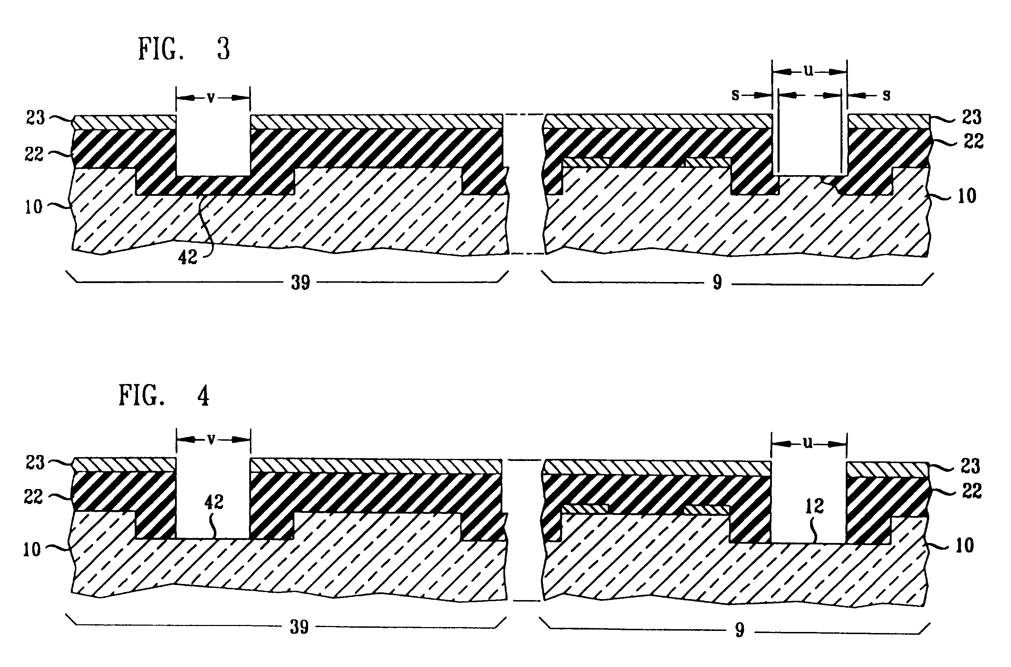

Next, the top surface of the mask portion 9, together with a dedicated auxiliary portion 39 (shown in FIG. 3, but not shown in FIGS. 1, 2, and 5) of the mask which is being repaired is subjected to a substantially anisotropic dry etching procedure at which the planarization layer 22 and the defect region 21 etch at substantially equal rates. FIG. 3 shows an intermediate stage of this etching procedure. Typically, this etching procedure is implemented with gaseous CF₄, or gaseous CHF₃, or a gaseous mixture of both, or a gaseous mixture of either or both with O₂. As a result, the (patterned) resist layer 24 tends to be removed and therefore is not shown in FIG. 3.

The auxiliary portion 39 (FIG. 3) of the mask which is being repaired has an auxiliary trench region whose top surface 42 has a width that is advantageously equal to the width w of the trench region in the mask portion 9--in order to facilitate fabrication of substantially equal thicknesses of the portion of the planarization layer 22 overlying the trench region that is located in the auxiliary portion 39 and the portion of the planarization layer 22 overlying the trench region that is located in the mask portion 9. This equality of these thicknesses ensures proper etch-stopping functioning by the auxiliary mask portion 39.

As viewed from above, the auxiliary trench region typically has a contour in the form either of a square or of parallel lines. The aperture in the chromium layer 23 located in the auxiliary mask portion 39 has a width v that is advantageously equal to u. The purpose of the auxiliary trench region is to act as an etch stop (indicator), as more fully explained below.

Advantageously further, in order to enhance the intensity of the etch stop indication, there is a plurality of such auxiliary trench regions, such that the total surface area covered by the apertures (each of width v) in the auxiliary mask portion 39 is equal to approximately 1 cm². Advantageously, each of these auxiliary trench regions has the same width w as that of the trench region located in the mask portion 9. Moreover, these auxiliary trench regions advantageously are physically separated from one another and thus are not coalesced into a single trench region, in order that the thickness of the planarization layer 22 overlying the top surface 12 of trench region located in the mask portion 9 substantially approximates the thickness of the planarization layer 22 overlying the plurality of auxiliary trench regions, and hence again in order to ensure proper etch-stop functioning by the auxiliary mask portion 39.

The anisotropic etching of the planarization layer 22 thus forms cuts of widths u and v therein overlying the mask portion 9 and the auxiliary mask portion 39, respectively. This etching is terminated (FIG.4) when a signal from the auxiliary trench region indicates that the anistroptic etching has progressed to the point that it has just reached the top surface 42 of the auxiliary trench region(s) located in the (now) cut auxiliary portion 49 and hence automatically also has just reached the top surface 12 of the trench region of the mask portion 9. This signal can be generated, for example, by detection of the light emitted in the plasma caused by radioactive transitions of decomposition products produced during the anisotropic etching and emanating only from the planarization layer 22 in the plurality of auxiliary trench regions.

Because of the substantial equality of etch rates of the planarization layer 22 and of the substrate 10, as well as the substantial equality of the thicknesses of the respective portions of this planarization layer that are located overlying the trench regions located in the mask portion 9 and in the auxiliary portion 39, this etching has removed the defect region 21, as is desired--that is, in such a way that the top surface 12 of the trench region is substantially planar, viz., with a depth everywhere equal to h.

Finally the remaining (remnants of the) planarization layer 22 can be removed, typically by means of a wet solvent, whereby the chromium layer 23 is also automatically removed (FIG.5) and the desired repaired mask portion 59 is formed.

In case the excess material forms a defect region located on the plateau region 11, this defect region can be removed in the same way as described above, except that now the apertures in the planarization layer 22 will be located overlying both this defect region itself (plus the safety margin) and plateau regions located in the auxiliary portion 39.

FIG. 6 depicts the phase-shifting mask portion 19 to be repaired and thus to form a repaired phase-shifting mask portion 159 (FIG.10). The mask portion 19 includes a transparent essentially quartz substrate 110 having a raised plateau region 111 with a top surface 112 and a width x. As used herein, the term "essentially quartz" includes commercial grade quartz, viz., non-pure quartz as is commercially available. The substrate 110 also has a trench (thinner) region with a top surface 114 and a width w. The top surface 114 of the trench region is located at a depth h beneath the top surface 112 of the plateau region 111. A patterned opaque chromium layer pair 113 (hereinafter, simply "the chrome layer 113") is located on the top surface 112 of the plateau region 111. Typically, the depth h corresponds to a phase-shift of π radians. The purpose of the chromium layer 113 is to supply an optically opaque portion for the phase-shifting mask portion 19, as known in the art.

The phase-shifting mask portion 19 has an indentation defect region 121 illustratively located at the top surface 112 of the plateau region 111. It is desired to repair the mask portion 19 insofar as this defect region 121 is concerned. This defect region 121 can have a variable height--i.e., a height that varies with lateral (two-dimensional) position along the surface 112.

The outermost lateral (two-dimensional) contours of the defect region are determined first, such as by an inspection with a two-dimensional scanning optical microscope.

Referring now to FIG. 7, there are then successively formed on the top surface of the mask portion 19, as well as typically on the top surface of the rest of the mask (not shown), layers 122, 123, and 124. Layer 122 is a planarization layer, typically a spun-on, essentially polymer layer, such as a polycresolformaldehyde or a polyvinylphenol, as are commercially available. Advantageously this planarization layer possesses anisotropic etching conditions for which it etches at substantially the same rate as that of the (quartz) substrate 110. Layer 123 is essentially chromium (possibly intermixed with some chromium oxide or other impurities) having a uniform thickness typically equal to about 0.03 µm; and layer 124 is a positive or negative tone resist layer--preferably positive tone--having a uniform thickness equal to about 0.5 µm. The thickness of planarization layer 122 at areas overlying the surface 112 of the plateau region 111 is typically equal to about 1 µm.

The resist layer 124 is exposed to a patterned beam of actinic radiation (ion beam, photon beam, or electron beam), the two-dimensional contours of the pattern being substantially the same as those of the previously determined (outermost) two-dimensional contours of the defect region 121 plus a non-zero safety margin having a width equal to s. Thus this alignment of the contours of the actinic radiation with those of the defect region need not be precise, so long as there is any safety margin (provided that the defect region 121 does not extend to an edge of the plateau region). The width s of this safety margin depends on the accuracy of the method used for ascertaining the (outermost) contours of the defect region 121, as well as depends on the width x of the plateau region 111. Typically is width s is about 0.5 µm or less.

Next, the resist layer 124 is developed, typically by a wet development, whereby it becomes a patterned resist layer. This pattern of the thus patterned resist layer 124 is then transferred to the chromium layer 123, typically by means of a standard technique such as anisotropic dry etching with a gas mixture of *Cl and O*_{*2.*} ₂ Alternatively, by virtue of the relatively small thickness of the chromium layer 123 with respect to undercut tolerance, isotropic wet etching--for example, with ceric ammonium nitrate solution--can also be used without inducing an unwanted undercut of the chrome features located underneath the resist features. The thus patterned chromium layer 123 will have an aperture of width equal to u overlying the defect region 121, with u being equal to the width of the defect region 121 plus twice the safety margin s.

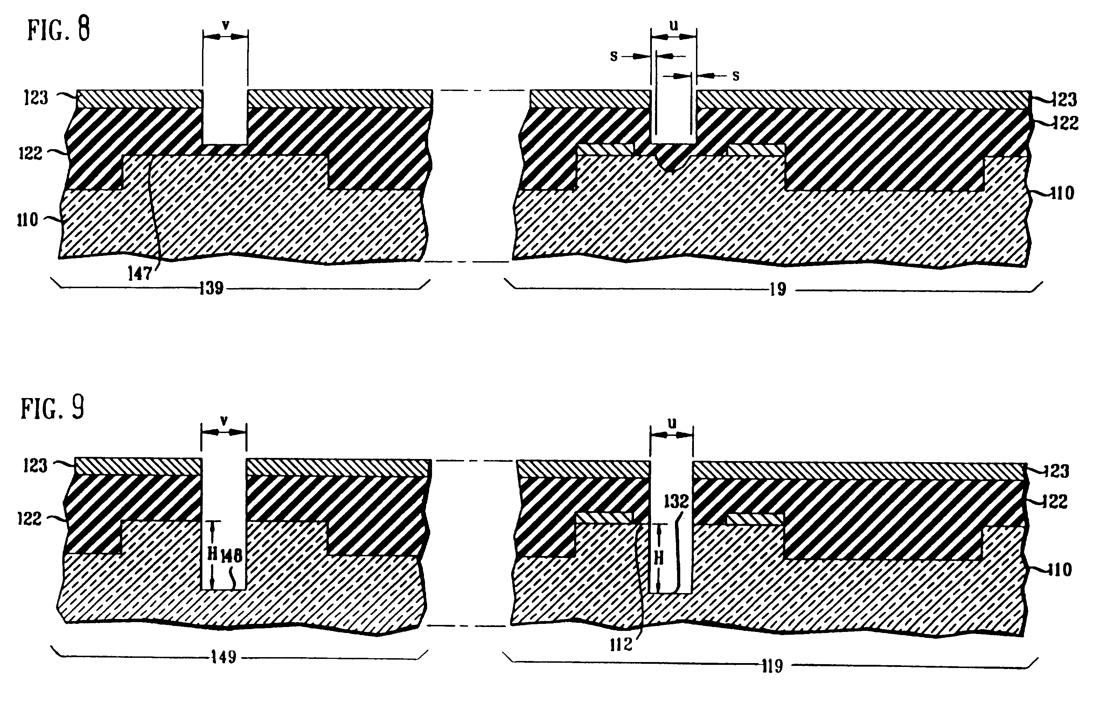

Next, the top surface of the mask portion 19, together with a dedicated auxiliary portion 139 (shown in FIG.8, but not shown in FIGS.6,7, and 10) of the mask which is being repaired is subjected to substantially anisotropic dry etching procedure at which the planarization layer 122 and the (quartz) substrate 110 (including its plateau region 111) etch at substantially equal rates. FIG.8 shows an intermediate stage of this etching procedure. Typically, this etching procedure is implemented with gaseous *CF*_{*4*} or gaseous *CHF*_{*3*} or a gaseous mixture of both, or a gaseous mixture of either or both with *O*_{*2*} As a result, the (patterned) resist layer 124 tends to be removed and therefore is not shown in FIG.8.

The auxiliary portion 139 (FIG.8) of the mask which is being repaired has an auxiliary plateau region whose top surface 147 has a width that is advantageously equal to the width x of the plateau region 111 located in the mask portion 19--in order to facilitate fabrication of substantially equal thicknesses of the portion of the planarization layer 122 overlying the plateau region that is located in the auxiliary portion 139 and the portion of the planarization layer 122 overlying the plateau region that is located in the mask portion 19. This equality of these thicknesses ensures proper etch-stopping functioning by the auxiliary mask portion 139.

As viewed from above, the auxiliary plateau region typically has contours in the form either of squares or of parallel lines. The aperture in the chromium layer 123 located in the auxiliary mask portion 139 has a width v that is advantageously equal to u. The purpose of the auxiliary plateau region is to act as an etch stop (indicator), as more fully explained below.

Advantageously further, in order to enhance the intensity of the etch stop indication, there is a plurality of such auxiliary plateau regions, such that the total surface area covered by the apertures (each of width v in the auxiliary mask portion 139 is equal to approximately 1 *cm*^{2.} Advantageously, each of these auxiliary plateau regions has the same width x as that of the plateau region 112 located in the mask portion 19. Moreover, these auxiliary plateau regions advantageously are physically separated from one another and thus are not coalesced into a single plateau region, in order that the thickness of the planarization layer 122 overlying the top surface 112 of plateau region located in the mask portion 19 substantially approximates the thickness of the planarization layer 122 overlying the plurality of auxiliary plateau regions, and hence again in order to ensure proper etch-stop functioning by the auxiliary mask portion 139.

The anistropic etching of the planarization layer 122 thus forms cuts of widths u and v therein overlying the mask portion 19 and the auxiliary mask portion 139, respectively. This etching is terminated (FIG.9) at an elapsed time T after a signal from the auxiliary trench region indicates that the anisotropic etching has progressed to the point that it has just reached the top surface 147 of the auxiliary plateau region(s) located in the (now) cut auxiliary portion 149 and hence automatically also has just reached the top surface 112 of the plateau region of the mask portion 19. This signal can be generated, for example, by detection of the light emitted in the plasma caused by radioactive transitions of decomposition products produced during the anisotropic etching and emanating only from the planarization layer 122 in the plurality of auxiliary plateau regions.

The aforementioned elapsed time T is made substantially equal to H/V, where H is equivalent to a phase shift of 2nπ (with n being an integer, preferably one), and where V is the (anistropic) etching rate in the substrate 110 (including the plateau region 111). Thus (FIG.9) this etching will produce a cut of width v penetrating through the surface 147 of the auxiliary plateau region located in the now cut auxiliary mask portion 149, this cut having a bottom surface 148 located at a depth H beneath the surface 147 of this auxiliary plateau region, where H is the equivalent of a phase shift of 2nπ. Likewise, this etching will produce a cut of width u penetrating through the surface 112 of the plateau region 111 located in the mask portion 19, this cut having a bottom surface 132 located also at a depth H beneath this surface 112.

Because of the substantial equality of etch rates of the planarization layer 122 and of the substrate 110, as well as the substantial equality of the thicknesses of the respective portions of this planarization layer that are located overlying the plateau regions located in the mask portion 19 and in the auxiliary portion 139, the above-described anisotropic etching will have repaired the mask portion 19 the defect region 121, as is desired--that is, in such a way that the surface 132 of the bottom of the cut is substantially planar, viz., with a depth everywhere substantially equal to H, where H is equivalent to a phase shift equal to 2nπ.

Finally the remaining (remnants of the) planarization layer 122 can be removed, typically by means of a wet solvent, whereby the chromium layer 123 is also automatically removed (FIG.10) and the desired repaired mask portion 159 is formed.

In case the indentation defect region is located on the top surface 114 of the trench region, this defect region can be removed in the same way as described above, except that now the apertures in the planarization layer 122 will be located overlying both this defect region itself (plus the safety margin) and trench regions located in the auxiliary portion 139.

In case there is a plurality of defect regions to be repaired, each defect region being located typically in a separate trench (or plateau) region, then the width u of a specific aperture overlying a specific defect region is still advantageously made equal to the width of the specific defect region plus twice the safety margin s. In the auxiliary portion 139, the widths v of the apertures in the chromium layer 123 and hence of the cuts in the planarization layer 122 then typically are all made equal to about 2 µm. Also, as viewed from above, the outer contours of these apertures and cuts in the auxiliary portion 139 are typically squares.

As an alternative to the above-described procedure, the planarization layer can be a polymer that is chosen such that it is sensitive to electron beam, ion beam, or photon (UV) beam radiation. By "sensitive" it is meant, for example, that upon exposure to an atmosphere of a vapor of an organometallic compound, such as an organoaluminum amide, the organometallic compound diffuses into the polymer and reacts with it to form an organometallic resist that is resistant to etching by fluorine-containing plasmas only in regions of the polymer that were not exposed to the radiation. The regions that are exposed to such radiation should overlie both the defect region and the portions of width v located in the auxiliary trench (or plateau) regions. In this way, an organometallic polymer that is etch-resistant to fluorine-containing plasmas is formed in those regions that overlie the complement of the defect region and the complement of the auxiliary trench (or plateau) regions. Thus the resist functions in a positive tone manner. Also, again the polymer is to be chosen such that in its exposed regions it will etch--typically, reactively ion etch with gaseous *CF*_{*4*} or gaseous *CHF*_{*3*}, or a gaseous mixture of both, or a gaseous mixture of either or both with *O*_{*2*} - at the same rate as that of the excess material or substrate.

For example, in conjunction with a focused ion beam, the polymer can be a polycresolformaldehyde. This polymer resist will crosslink in regions thereof that have been exposed to a focused ion beam; and thus the diffusion of the organometallic compound in the previously exposed regions of the resist will be suppressed, and the reaction of the organometallic compound with the previously exposed regions of the resist will also be suppressed, whereby this polymer will behave as a positive tone resist.

As a further option, the polymer is chosen such than an etch-resistant organometallic resist is formed only in those regions that were exposed to the radiation, and these regions should overlie the complement both of the defect region and of the portions of width v located in the auxiliary trench (or plateau) regions. In this way, again an organometallic resist (that is resistant to etching by fluorine-containing plasmas) is formed in those regions that overlie the complement of the defect region and of the auxiliary trench (or plateau) regions--i.e., in a negative tone manner.

Although the invention has in described in detail with respect to specific embodiments, various modifications can be made without departing from the scope of the invention as defined in the claims. For example, the chrome layer 23 can be omitted in case the resist layer 24 itself is sufficiently durable so as to be usable as a patterned resist during the anisotropic etching of the planarization layer 22. Instead of chrome, other materials having a good dry-etch resistance during the defect region or substrate (quartz) etching can be used, for example aluminum having a thickness of about 0.03 µm, the aluminum being patterned typically by means of a gaseous chlorine plasma etching process. Instead of the aforementioned polymers, other materials can be used for the planarization layer 22, such as silicon dioxide or silicon nitride which have been chemically vapor deposited, or spun-on glass. Also, the chromium layer 23 can be removed, prior to removal of the planarization layer 22, by a known chromium etchant. Instead of quartz, the substrate can be essentially calcium fluoride or magnesium fluoride.

## Claims

1. A method of repairing a phase-shifting lithographic mask (9) in which the mask has a substrate (10), the substrate having a trench region (12) and a plateau region (11) each of which has a substantially planar top surface except in a defect region (21) located in one of the trench or plateau regions where excess material is present, comprising the steps of the steps of
(a) forming a first layer (22) having a substantially planar surface overlying at least the one of the trench or plateau regions where the excess material is present, the first layer having a portion overlying at least the lateral extent of the defect region, the portion having anisotropic etching conditions at which it anisotropically etches at substantially the same rate as that of the excess material; and
(b) anisotropically etching through the portion of the first layer and through the excess material until the etching reaches the level of the top surface of the one of the trench or plateau regions, the etching being performed at said anisotropic etching conditions.

2. A method of repairing a phase-shifting lithographic mask (9) in which the mask (9) has a substrate (10), the substrate (10) having a trench region (114) and a plateau region (111) each of which has a substantially planar top surface except in a defect region (121) located in one of the trench or plateau regions where an indentation region is present, comprising the steps of the steps of
(a) forming a first layer (22) having a substantially planar surface overlying at least the one of the trench or plateau regions where the indentation region is present, the first layer having a portion overlying at least the lateral extent of the defect region, the portion having anisotropic etching conditions at which it anisotropically etches at substantially the same rate as that of the substrate; and
(b) anisotropically etching both through the entire thickness of the portion of the first layer and through a thickness of the substrate underlying said portion of the first layer to a depth beneath the top surface of the one of the trench or plateau regions, the etching being performed at said anisotropic etching conditions.

3. The method of claim 1 or 2 FURTHER CHARACTERIZED IN THAT the first layer is a polymer.

4. The method of claim 1 or 2 FURTHER CHARACTERIZED BY the step of forming, prior to the etching, a second layer (23) on the top surface of the first layer, and forming an aperture in the second layer overlying at the last the entire lateral extent of the defect region, the second layer being resistant to the etching, whereby the aperture in the second layer defines the portion of the first layer.

5. The method of claim 4 FURTHER CHARACTERIZED IN THAT the second layer comprises a metal and the first layer is a polymer.

6. The method of claim 4 FURTHER CHARACTERIZED BY removing remnants of the first and second layers subsequent to the etching.

7. The method of claims 1, 2, 3, 4, 5 or 6 FURTHER CHARACTERIZED BY, prior to the etching, two-dimensionally inspecting the mask to determine the lateral extent of the defect region.

## Patentansprüche

1. Verfahren zur Reparatur einer phasenverschiebenden lithographischen Maske (9), bei dem die Maske ein Substrat (10) aufweist, wobei das Substrat einen Grabenbereich (12) und einen Plateaubereich (11) aufweist, die beide mit Ausnahme eines in dem Graben- oder dem Plateaubereich befindlichen Defektbereichs (21), in dem überschüssiges Material vorliegt, eine im wesentlichen planare obere Oberfläche aufweisen, mit den folgenden Schritten:
(a) Ausbilden einer ersten Schicht (22) mit einer im wesentlichen planaren Oberfläche, die über mindestens dem besagten Graben- oder Plateaubereich liegt, in dem überschüssiges Material vorliegt, wobei die erste Schicht einen Teil aufweist, der über mindestens der seitlichen Ausdehnung des Defektbereichs liegt, wobei der Teil anisotrope Ätzbedingungen aufweist, unter denen er sich anisotrop im wesentlichen mit derselben Geschwindigkeit ätzt wie das überschüssige Material; und
(b) anisotropes Ätzen durch den Teil der ersten Schicht und durch das überschüssige Material, bis das Ätzen die Ebene der oberen Oberfläche des besagten Graben- oder Plateaubereichs erreicht, wobei das Ätzen unter den besagten anisotropen Ätzbedingungen durchgeführt wird.

2. Verfahren zur Reparatur einer phasenverschiebenden lithographischen Maske (9), bei dem die Maske (9) ein Substrat (10) aufweist, wobei das Substrat einen Grabenbereich (114) und einen Plateaubereich (111) aufweist, die beide mit Ausnahme eines in dem Graben- oder dem Plateaubereich befindlichen Defektbereichs (21), in dem ein eingeprägter Bereich vorliegt, eine im wesentlichen planare obere Oberfläche aufweisen, mit den folgenden Schritten:
(a) Ausbilden einer ersten Schicht (22) mit einer im wesentlichen planaren Oberfläche, die über mindestens dem besagten Graben- oder Plateaubereich liegt, in dem der eingeprägte Bereich vorliegt, wobei die erste Schicht einen Teil aufweist, der über mindestens der seitlichen Ausdehnung des Defektbereichs liegt, wobei der Teil anisotrope Ätzbedingungen aufweist, unter denen er sich anisotrop im wesentlichen mit derselben Geschwindigkeit ätzt wie das Substrat; und
(b) anisotropes Ätzen sowohl durch die gesamte Dicke des Teils der ersten Schicht als auch durch eine Dicke des unter dem besagten Teil der ersten Schicht liegenden Substrats bis auf eine Tiefe unterhalb der oberen Oberfläche des besagten Graben- oder Plateaubereichs, wobei das Ätzen unter den besagten anisotropen Ätzbedingungen durchgeführt wird.

3. Verfahren nach Anspruch 1 oder 2, weiterhin dadurch gekennzeichnet, daß die erste Schicht ein Polymer ist.

4. Verfahren nach Anspruch 1 oder 2, weiterhin gekennzeichnet durch den Schritt des vor dem Ätzen erfolgenden Ausbildens einer zweiten Schicht (23) auf der oberen Oberfläche der ersten Schicht und der Ausbildung einer Apertur in der zweiten Schicht, die zum letzten über der gesamten seitlichen Ausdehnung des Defektbereichs liegt, wobei die zweite Schicht dem Ätzen widersteht, wodurch die Apertur in der zweiten Schicht den Teil der ersten Schicht definiert.

5. Verfahren nach Anspruch 4, weiterhin dadurch gekennzeichnet, daß die zweite Schicht ein Metall umfaßt und die erste Schicht ein Polymer ist.

6. Verfahren nach Anspruch 4, weiterhin gekennzeichnet durch das Entfernen der Überreste der ersten und zweiten Schicht nach dem Ätzen.

7. Verfahren nach den Ansprüchen 1, 2, 3, 4, 5, 6, weiterhin gekennzeichnet durch das vor dem Ätzen erfolgende zweidimensionale Inspizieren der Maske zur Bestimmung der seitlichen Ausdehnung des Defektbereichs.

## Revendications

1. Procédé de réparation d'un masque lithographique à décalage de phase (9) dans lequel le masque a un substrat (10), le substrat ayant une région de tranchée (12) et une région de plateau (11) qui ont chacune une surface supérieure substantiellement plane sauf dans une région de défaut (21) située dans une des régions de tranchée ou de plateau où un excès de matière est présent, comprenant les étapes de
(a) formation d'une première couche (22) ayant une surface substantiellement plane recouvrant au moins celle des régions de tranchée ou de plateau où l'excès de matière est présent, la première couche ayant une partie recouvrant au moins l'étendue latérale de la région de défaut, la partie ayant des conditions de gravure anisotrope auxquelles elle grave anisotropiquement à substantiellement la même vitesse que la vitesse de gravure de l'excès de matière ; et
(b) gravure anisotrope à travers la partie de la première couche et à travers l'excès de matière jusqu'à ce que la gravure atteigne le niveau de la surface supérieure de celle des régions de tranchée ou de plateau, la gravure étant effectuée auxdites conditions de gravure anisotrope.

2. Procédé de réparation d'un masque lithographique à décalage de phase (9) dans lequel le masque (9) a un substrat (10), le substrat (10) ayant une région de tranchée (114) et une région de plateau (111) qui ont chacune une surface supérieure substantiellement plane sauf dans une région de défaut (121) située dans une des régions de tranchée ou de plateau où une région d'empreinte est présente, comprenant les étapes de
(a) formation d'une première couche (22) ayant une surface substantiellement plane recouvrant au moins celle des régions de tranchée ou de plateau où la région d'empreinte est présente, la première couche ayant une partie recouvrant au moins l'étendue latérale de la région de défaut, la partie ayant des conditions de gravure anisotrope auxquelles elle grave anisotropiquement à substantiellement la même vitesse que la vitesse de gravure du substrat ; et
(b) gravure anisotrope à la fois à travers toute l'épaisseur de la partie de la première couche et à travers une épaisseur du substrat sous-jacent à ladite partie de ladite première couche jusqu'à une profondeur en dessous de la surface supérieure de celle des régions de tranchée ou de plateau, la gravure étant effectuée auxdites conditions de gravure anisotrope.

3. Procédé selon la revendication 1 ou 2, CARACTERISE EN OUTRE EN CE QUE la première couche est un polymère.

4. Procédé selon la revendication 1 ou 2, CARACTERISE EN OUTRE PAR l'étape de formation, avant la gravure, d'une deuxième couche (23) sur la surface supérieure de la première couche, et la formation d'une ouverture dans la deuxième couche recouvrant au moins toute l'étendue latérale de la région de défaut, la deuxième couche résistant à la gravure, par lequel l'ouverture dans la deuxième couche définit la partie de la première couche.

5. Procédé selon la revendication 4, CARACTERISE EN OUTRE EN CE QUE la deuxième couche comprend un métal et la première couche est un polymère.

6. Procédé selon la revendication 4, CARACTERISE EN OUTRE PAR l'élimination des restes des première et deuxième couches après la gravure.

7. Procédé selon les revendications 1, 2, 3, 4, 5 ou 6, CARACTERISE EN OUTRE PAR, avant la gravure, l'inspection bidimensionnelle du masque pour déterminer l'étendue latérale de la région de défaut.
